# EUROPEAN PATENT APPLICATION

(11) **EP 2 133 625 A1**
(43) Date of publication of application: **16.12.2009**
(21) Application number: 08010456.5
(22) Date of filing: 09.06.2008
(51) Int. Cl.: F21V 29/00, F21K 7/00, F21Y 101/02

(54) **Light emitting diode lamp high heat-dissipation capacity**

(71) Applicant: Chen, Hon-Wen, Yilan County (TW)
(72) Inventor: Chen, Hon-Wen, Yilan County (TW)
(74) Representative: Kador & Partner

(57) **Abstract**

This invention relates to a light emitting diode lamp (1) with high heat-dissipation capacity wherein the lamp (1) has at least one heat sink unit (11), a plurality of air-flow channels (113) being provided within each heat sink unit (11), an electrical insulation layer (12) with high heat-conductivity being provided on the surface of the light emitting diode (14) mounted with heat sink unit (11), a metal circuit (13) being formed on the electrical insulation layer (12) with high heat-conductivity according to demand, at least one light emitting diode (14) being packaged on the metal circuit (13) such that provision of circuit board or coating of heat sink paste become unnecessary for the lamp (1).

## Description

### BACKGROUND OF THE INVENTION

### 1. Field of the invention

This invention relates to a light emitting diode lamp with high heat-dissipation capacity, particularly to a lamp without the additional need of a circuit board, and the lamp itself has heat sink unit so as to obtain performance with good heat dissipation efficiency.

### 2. Brief Description of the Prior Art

Accompanying with perpetual increase of the power of light emitting diode (LED), the working waste heat of LED is relatively increased. Thus, the exhaust of the waste heat is relatively important. When reviewing the present method of heat dissipation for LED lamp, for example the working waste heat of LED contacts with the heat sink through the circuit board and heat sink paste, there are still major defects of heat resistance in the present method of heat dissipation for LED lamp listed as follow, which result in the increased temperature of the LED, reduction on working efficiency and even the damage of LED.
1. A layer of polymer with high heat-resistance for insulation package exists between the heat sink and the LED components.
2. LED is mounted on the polymer circuit board with high heat-resistance insulation.
3. Heat sink paste is used between the layers of the structure.

So far, the way of solving the above heat-resistance problem is mostly to increase the area of heat sink or to raise the rotation speed of fan so as to enhance the heat dissipation efficiency. However, this measure of increasing the efficiency in the heat sink terminal fails to contribute efficiently and reasonably to the improvement or solution with respect to the heat transfer efficiency between the heat source (i.e., the LED) and the heat dissipating terminal (i.e., the heat sink).

Thus, there are several ways developed to solve the above heat dissipation problem listed as below.

Firstly, in Japanese Patent No. JP2004-200347, this technology only improves the heat dissipation structure in the interior of the LED, thus does not provide any efficient solution with respect to the heat jamming in the insulation package layer with high heat-resistance outside the LED.

Secondly, in Japanese Patent No. JP-Heisei 5-347369, this technology improves heat dissipation problem of package layer on the upper portion of electronic components, but fails to solve defect problem of interface between the insulated circuit board with high heat-resistance and the heat sink paste.

Thirdly, in PRC Patent No. CN15455148, this technology did not propose a total solution for heat transfer including the items of lowering heat-resistance channels, reducing the complexity of heat conduction structure and the number of interface, ensuring the interface bubbles of the heat sink paste in the case of practical application.

### SUMMARY OF THE INVENTION

The main object of the light emitting diode lamp with high heat-dissipation capacity of the present invention is to provide a lamp in which the lamp body itself is a heat dissipation structure, a metal circuit being directly created on the lamp body so that no additional circuit boards are needed. Furthermore, heat resistance between structure layers can be lowered so as to achieve the effectiveness of exhausting the waste heat promptly and concretely from the heat source.

In one aspect of the present invention, a light emitting diode lamp with high heat-dissipation capacity is provided, comprising :
a heat sink unit, having a plurality of air-flow channels, a heat absorption end and a heat emitting end;
an electrical insulation layer with high heat conductivity laminated on the heat absorption end of the heat sink unit;
a metal circuit created on the electrical insulation layer with high heat conductivity; and
at least one light emitting diode packaged on the metal circuit.

Preferably, the heat absorption end of the heat sink unit is selected from a design of a flat surface, a concave surface or a convex surface.

In another aspect of the present invention, a light emitting diode lamp with high heat-dissipation capacity is provided, comprising :
a heat sink unit, having a plurality of air-flow channels, a heat absorption end and a heat emitting end;
at least one lamp body releasably combined with the heat sink unit, an electrical insulation layer with high heat conductivity being formed on the surface of the lamp body, a metal circuit being further created on the electrical insulation layer with high heat conductivity according to demand, and at least one light emitting diode being packaged on the metal circuit.

Preferably, the heat absorption end of the heat sink unit is selected from a design of a flat surface, a concave surface or a convex surface.

The light emitting diode lamp is provided with a heat pipe or a thermoelectric cooling chip between the lamp body and the heat sink unit.

For the aforesaid two embodiments, the electrical insulation layer with high heat conductivity is formed by a laminating method selected from vapor deposition, sputtering, stamping, injecting, screen printing, sintering and spin-coating. The material of the electrical insulation layer with high heat conductivity is a constitution formed by a material selected from one or more of diamond, aluminum nitride, silicon carbide and diamond powder mixing with polymer material, diamond-like carbon or nano diamond.

For the aforesaid two embodiments, the air-flow channels of the heat sink unit is defined to have at least two openings opposite to each other and to communicate with outside thereby.

For the aforesaid two embodiments, the included angle between each air-flow channel and the vertical axis is in the range of 0∼60 degree.

For the aforesaid two embodiments, the surface of the heat emitting end is provided with a micro-structure selected from micro-pit, micro-protrusion, porosity or sponge-like opening, and a heat radiation layer is formed on the micro-structure by a method selected from vapor deposition, sputtering, electrolyzing, sintering and spin-coating. The material of the heat radiation layer is selected from one or more of diamond, aluminum nitride, silicon carbide, diamond-like carbon or nano diamond.

For the aforesaid two embodiments, a plurality of fins are provided on the heat emitting end of the heat sink unit, and the air-flow channels are each located between every two-fins.

Each of the air-flow channels further has an opening which is communicating with the two openings opposite to each other.

A closing surface is further provided to connect between every two-fin, and at least one air inlet hole is provided on the closing surface.

For the aforesaid two embodiments, each fin is provided with a micro-structure selected from micro-pit, micro-protrusion, porosity or sponge-like opening, and a heat radiation layer is formed on the micro-structure by a method selected from vapor deposition, sputtering, electrolyzing, sintering and spin-coating. The material of the heat radiation layer is selected from one or more of diamond, aluminum nitride, silicon carbide, diamond-like carbon or nano diamond.

In still another aspect of the present invention, a light emitting diode lamp with high heat-dissipation capacity is provided, comprising :
a heat sink unit having a heat absorption end and a heat emitting end, the heat emitting end is provided with a micro-structure selected from micro-pit, micro-protrusion, porosity or sponge-like opening, and a heat radiation layer is formed on the micro-structure;
an electrical insulation layer with high heat conductivity formed on the heat absorption end of the heat sink unit;
a metal circuit created on the electrical insulation layer with high heat conductivity; and
at least one light emitting diode packaged on the metal circuit.

### BRIEF DESCRIPTION OF THE DRAWINGS

Figure 1 is a first perspective outline view of the first embodiment of the light emitting diode lamp with high heat-dissipation capacity of the present invention.
Figure 2 is a perspective outline view of a plate type heat sink unit of the present invention with a closing surface.
Figure 3 is a second perspective outline view of the first embodiment of the light emitting diode lamp with high heat-dissipation capacity of the present invention.
Figure 4 is a third perspective outline view of the first embodiment of the light emitting diode lamp with high heat-dissipation capacity of the present invention.
Figure 5 is a fourth perspective exploded view of the first embodiment of the light emitting diode lamp with high heat-dissipation capacity of the present invention.
Figure 6 is a fifth perspective exploded view of the first embodiment of the light emitting diode lamp with high heat-dissipation capacity of the present invention.

### DETAILED DESCRIPTION OF THE PREFERRED EMBODIMENTS

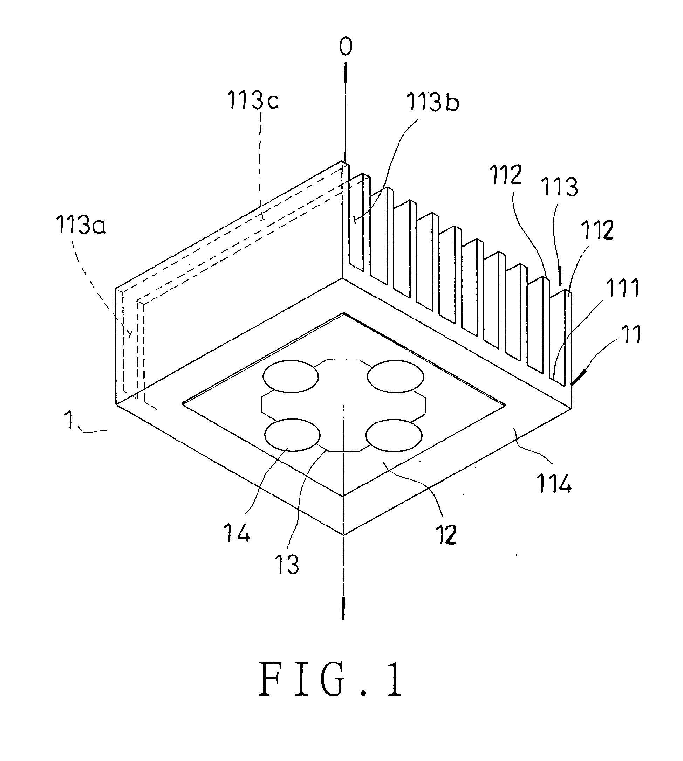

Referring to Figure 1, the light emitting diode lamp (1) with high heat-dissipation capacity comprises a plate type heat sink unit (11). A plurality of fins (112) are provided on the heat emitting end (111) to extend along the axial direction (0) of the heat sink unit (11). An air-flow channel (113) is defined between two fins (112), which has two openings (113a), (113b) opposite to each other and a third opening (113c) communicating with both openings (113a), (113b). An electrical insulation layer (12) with high heat conductivity is formed on the heat absorption end (114) of the heat sink unit (11) by a lamination method selected from vapor deposition, sputtering, stamping, injection, screen printing, sintering or spin-coating. The material of the electrical insulation layer (12) with high heat conductivity is a constitution formed by a material selected from one or more of diamond, aluminum nitride, silicon carbide and diamond powder mixing with polymer material, diamond-like carbon or nano diamond. A metal circuit (13) is created on the electrical insulation layer (12) with high heat conductivity, and at least one light emitting diode (14) is packaged on the metal circuit (13).

Furthermore, the heat absorption end (114) of the heat sink unit (11) of the light emitting diode lamp (1) with high heat-dissipation capacity in this embodiment is a flat surface, concave surface or a convex surface design.

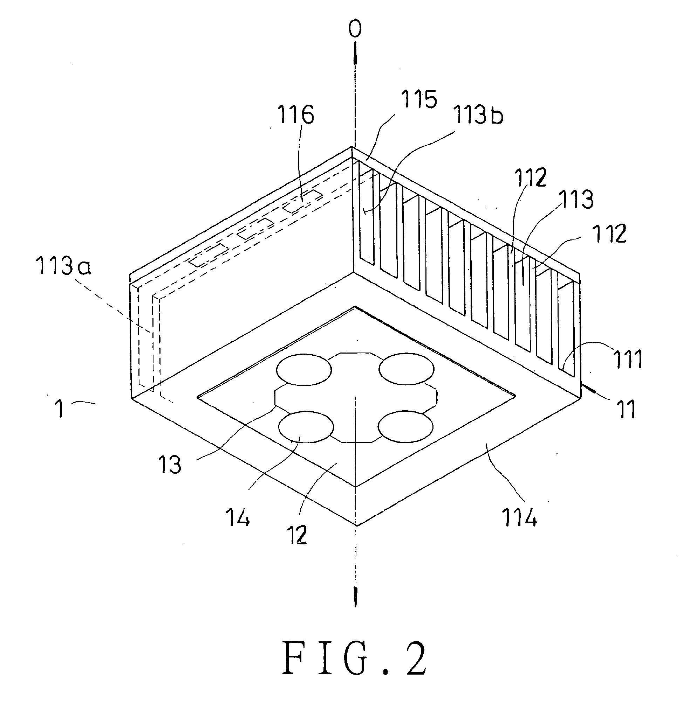

As shown in Figure 2, the light emitting diode lamp (1) with high heat-dissipation capacity further has a closing surface (115) connected between every two fins (112) such that the air-flow channel (113) presents only two openings (113a), (113b) opposite to each other. At least one air inlet hole (116) is provided on the closing surface (115).

Furthermore, the surface of each fin (112) of the heat sink unit (11) is provided with micro-structure which can increase the specific surface area of the heat sink unit (11). The micro-structure is presented as the shape of micro-pit, micro-protrusion, porosity or sponge-like opening, and a heat radiation layer is formed on the surface of the micro-structure by vapor deposition, sputtering, electrolyzing, sintering or spin-coating. The material of the heat radiation layer is selected from one or more of diamond, aluminum nitride, silicon carbide, diamond-like carbon or nano diamond.

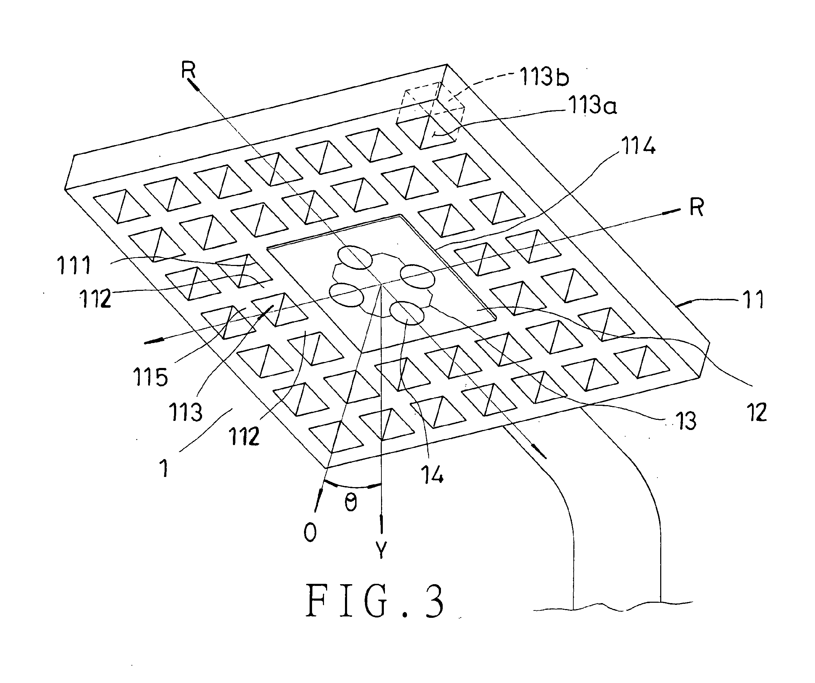

Further referring to Figure 3, a plurality of fins (112) of the light emitting diode lamp (1) with high heat-dissipation capacity are provided on the heat emitting end (111) of the heat sink unit (11) to extend along the radial direction (R) of the heat sink unit (11). A closing surface (115) is provided to connect between every two fins (112). Furthermore, the light emitting diode lamp (1) with high heat-dissipation capacity can be applied as road lamp while the included angle defined between the air-flow channel (113) of the heat sink unit (11) and the vertical axis (Y) is in the range of 0∼60 degrees.

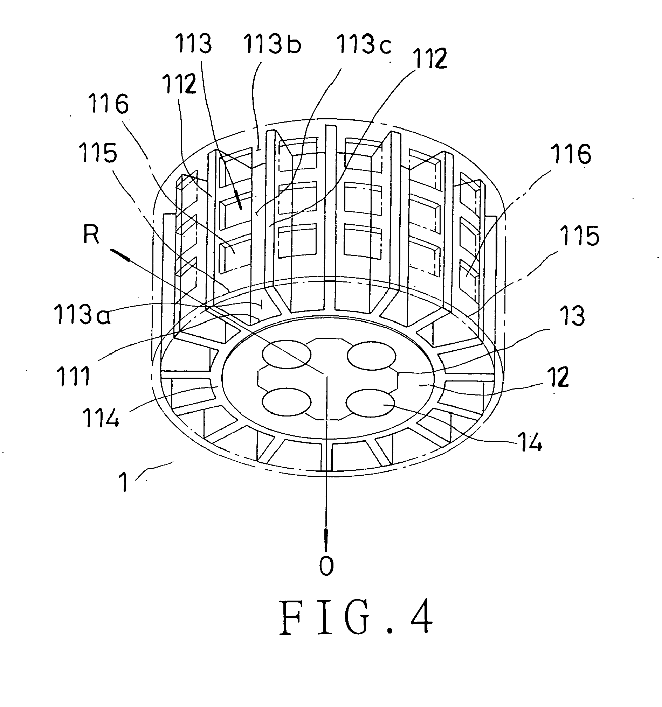

Referring to Figure 4, the heat sink unit (11) of the light emitting diode lamp (1) with high heat-dissipation capacity is formed as tubular shape body, in which a plurality of fins (112) are provided to extend along the radial direction (R) of the heat sink unit (11) likewise, and at least one air inlet hole (116) is provided on the closing surface (115).

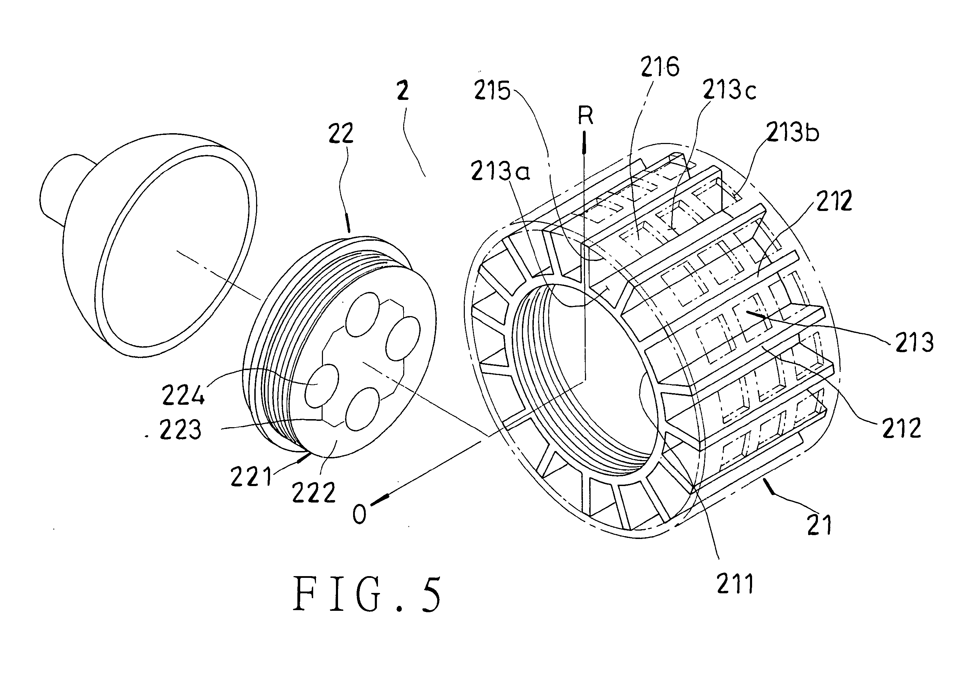

Referring to Figure 5, the light emitting diode lamp (2) with high heat-dissipation capacity has a heat sink unit (21) and a lamp body (22) in which the lamp body (22) is releasably combined with the heat sink unit (21). The heat sink unit (21) in this embodiment is a tubular shape body, A plurality of fins (212) are provided on the heat emitting end (211) of the heat sink unit (21) to extend along the radial direction (R) of the heat sink unit (21). An air-flow channel (213) is defined between every two fins (212) and each air-flow channel (213) has two openings (213a), (213b) opposite to each other and a third opening (213c) communicating with both openings (213a), (213b). The surface (221) of the lamp body (22) is of flat surface, concave surface or convex surface design, An electrical insulation layer (222) with high heat conductivity is formed on the absorption end (221) of the lamp body (22) by a lamination method selected from vapor deposition, sputtering, stamping, injection, screen printing, sintering or spin-coating. The material of the electrical insulation layer (222) with high heat conductivity is a constitution formed by a material selected from one or more of diamond, aluminum nitride, silicon carbide and diamond powder mixing with polymer material, diamond-like carbon or nano diamond. A metal circuit (223) is created on the electrical insulation layer (222) with high heat conductivity; and at least one light emitting diode (224) is packaged on the metal circuit (223).

The light emitting diode lamp (2) with high heat-dissipation capacity shown in Figure 12 further has a closing surface (215) connected between every two fins (212) on the heat emitting end (211) of the heat sink unit (21). An air-flow channel (213) is defined by a space enclosed by two fins (212) and a closing surface (215), which has two openings (213a), (213b) opposite to each other. At least one air inlet hole (216) is provided on the closing surface (215).

Furthermore, the surface of each fin (212) of the heat sink unit (21) is provided with micro-structure which can increase the specific surface area of the heat sink unit (21). The micro-structure is presented as the shape of micro-pit, micro-protrusion, porosity or sponge-like opening, and a heat radiation layer is formed on the surface of the micro-structure by vapor deposition, sputtering, electrolyzing, sintering or spin-coating. The material of the heat radiation layer is selected from one or more of diamond, aluminum nitride, silicon carbide, diamond-like carbon or nano diamond.

The releasable combination of the above heat sink unit (21) and the lamp body (22) can be conducted by mutual threaded engagement, interlock of hook and engaging slot, and screw fastener. In addition, the light emitting diode lamp (2) with high heat-dissipating capacity is provided with a heat pipe or a thermoelectric cooling chip (not shown in the figures) between the lamp body (22) and the heat sink unit (21) so that the heat generated by the lamp body (22) can be introduced promptly into the heat sink unit (21).

Preferably, a plurality of lamp body (22) is releasably installed on the heat sink unit (21) so that the light emitting diode lamp (2) with high heat-dissipation capacity of the present invention can be applied as car lamp.

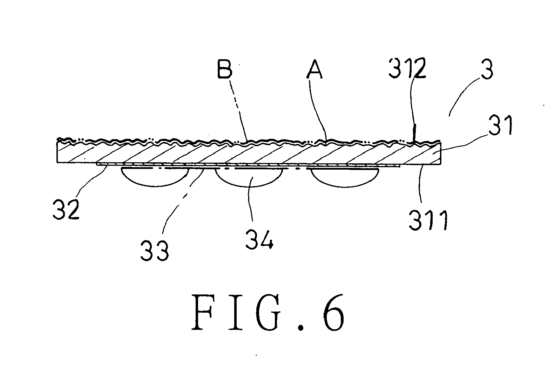

Referring to Figure 6, a light emitting diode lamp (3) with high heat-dissipation capacity of still another one aspect of the present invention is shown, comprising:
a heat sink unit (31) having a heat absorption end (311) and a heat emitting end (312), the heat emitting end (312) being provided with one micro-structure (A) selected from micro-pit, micro-protrusion, porosity or sponge-like opening, and a heat radiation layer (B) being formed on the surface of the micro-structure (A) by vapor deposition, sputtering, electrolyzing, sintering or spin-coating, the material of the heat radiation layer (B) being selected from one or more of diamond, aluminum nitride, silicon carbide, diamond-like carbon or nano diamond.
an electrical insulation layer (32) with high heat conductivity created on the heat absorption end (314) of the heat sink unit (31) by a lamination method selected from vapor deposition, sputtering, stamping, injection, screen printing, sintering or spin-coating, the material of the electrical insulation layer (32) with high heat conductivity being a constitution formed by a material selected from one or more of diamond, aluminum nitride, silicon carbide and diamond powder mixing with polymer material, diamond-like carbon or nano diamond;
a metal circuit (33) created on the electrical insulation layer (32) with high heat conductivity;
at least one light emitting diode (34) packaged on the metal circuit (33).

## Claims

1. A light emitting diode lamp (1) with high heat-dissipation capacity, wherein it comprises :
a heat sink unit (11) having a plurality of air-flow channels (113), a heat absorption end (114) and a heat emitting end (111);
an electrical insulation layer (12) with high heat conductivity laminated on said heat absorption end (114) of said heat sink unit (11);
a metal circuit (13) being created on the electrical insulation layer (12) with high heat conductivity; and at least one light emitting diode (14) packaged on the metal circuit (13).

2. A light emitting diode lamp with high heat-dissipation capacity as claimed in claim 1, wherein the material of said electrical insulation layer (12) with high heat conductivity is a constitution formed by a material selected from one or more of diamond, aluminum nitride, silicon carbide and diamond powder mixing with polymer material, diamond-like carbon or nano diamond.

3. A light emitting diode lamp with high heat-dissipation capacity as claimed in claim 1, wherein said heat absorption end (114) of said heat sink unit (11) is selected from a design of a flat surface, a concave surface or a convex surface.

4. A light emitting diode lamp with high heat-dissipation capacity as claimed in claim 1, wherein said air-flow channels (113) is defined to have at least two openings (113a) (113b) opposite to each other and to communicate with outside thereby, and an included angle between each said air-flow channel (113) and the vertical axis is in the range of 0∼60 degree.

5. A light emitting diode lamp with high heat-dissipation capacity as claimed in claim 1, wherein said air-flow channels (113) is defined to have at least two openings (113a) (113b) opposite to each other and to communicate with outside thereby and the surface of said heat emitting end (111) of said heat sink unit (11) is provided with a micro-structure (A) selected from micro-pit, micro-protrusion, porosity or sponge-like opening capable of increasing the specific surface area, and a heat radiation layer (B) is formed on the surface of said micro-structure (A).

6. A light emitting diode lamp with high heat-dissipation capacity as claimed in claim 1, wherein a plurality of fins (112) are provided on the heat emitting end (111) of said heat sink unit (11), and said air-flow channels (113) each located between every two-fins (112) have at least two openings (113a) (113b) opposite to each other and a third opening (113c) communicating with said two openings (113a) (113b).

7. A light emitting diode lamp with high heat-dissipation capacity as claimed in claim 1, wherein a plurality of fins (112) are provided on the heat emitting end (111) of said heat sink unit (11), and said air-flow channels (113) each located between every two-fins (112) have at least two openings (113a) (113b) opposite to each other and a closing surface (115) is further provided to connect between every two-fins (112), and at least one air inlet hole (116) is provided on said closing surface (115).

8. A light emitting diode lamp (2) with high heat-dissipation capacity, wherein it comprises :
a heat sink unit (21) having a plurality of air-flow channels (213) and a heat emitting end (211);
at least one lamp body releasably combined with said heat sink unit (21), an electrical insulation layer (222) with high heat conductivity being formed on the absorption end (221) of said lamp body (22), a metal circuit (223) being further created on said electrical insulation layer (222) with high heat conductivity according to demand, and at least one light emitting diode (224) being packaged on said metal circuit (223).

9. A light emitting diode lamp with high heat-dissipation capacity as claimed in claim 8, wherein the material of said electrical insulation layer (222) with high heat conductivity is a constitution formed by a material one or more of diamond, aluminum nitride, silicon carbide and diamond powder mixing with polymer material, diamond-like carbon or nano diamond.

10. A light emitting diode lamp with high heat-dissipation capacity as claimed in claim 8, wherein said heat absorption end (221) of said lamp body (22) is selected from a design of a flat surface, a concave surface or a convex surface.

11. A light emitting diode lamp with high heat-dissipation capacity as claimed in claim 8, wherein said air-flow channels (213) is defined to have at least two openings (213a) (213b) opposite to each other and to communicate with outside thereby, and an included angle between each said air-flow channel (213) and the vertical axis is in the range of 0∼60 degree.

12. A light emitting diode lamp with high heat-dissipation capacity as claimed in claim 8, wherein said air-flow channels (213) is defined to have at least two openings (213a) (213b) opposite to each other and to communicate with outside thereby and the surface of said heat emitting end (211) of said heat sink unit (21) is provided with a micro-structure selected from micro-pit, micro-protrusion, porosity or sponge-like opening capable of increasing the specific surface area, and a heat radiation layer is formed on the surface of said micro-structure.

13. A light emitting diode lamp with high heat-dissipation capacity as claimed in claim 8, wherein said air-flow channels (213) each located between every two-fins (212) have at least two openings (213a) (213b) opposite to each other and a third opening (213c) communicating with said two openings (213a) (213b).

14. A light emitting diode lamp with high heat-dissipation capacity as claimed in claim 8, wherein a plurality of fins (212) are provided on the heat emitting end (211) of said heat sink unit (21), and said air-flow channels (213) each located between every two-fins (212) have at least two openings (213a) (213b) opposite to each other and a closing surface (215) is further provided to connect between every two-fin, and at least one air inlet hole (216) is provided on said closing surface (215).

15. A light emitting diode lamp with high heat-dissipation capacity as claimed in claim 8, wherein said air-flow channels (213) each located between every two-fins (212) have at least two openings (213a) (213b) opposite to each other and each fin is provided with a micro-structure selected from micro-pit, micro-protrusion, porosity or sponge-like opening, and a heat radiation layer is formed on said micro-structure.

16. A light emitting diode lamp with high heat-dissipation capacity as claimed in claim 8, wherein a heat pipe or a thermoelectric cooling chip is provided between said lamp body (22) and said heat sink unit (21).

17. A light emitting diode lamp with high heat-dissipation capacity, wherein it comprises :
a heat sink unit (31) having a heat absorption end (311) and a heat emitting end (312), said heat emitting end (312) being provided with a micro-structure capable of increasing specific surface area , and a heat radiation layer being formed on said micro-structure;
an electrical insulation layer (32) with high heat conductivity laminated on said heat absorption end (311) of said heat sink unit (31);
a metal circuit (33) formed on said electrical insulation layer (32) with high heat conductivity; and
at least one light emitting diode (34) packaged on said metal circuit (33).
